# EUROPÄISCHE PATENTSCHRIFT

(11) **EP 3 567 129 B1**
(45) Veröffentlichungstag und Bekanntmachung des Hinweises auf die Patenterteilung: **11.12.2024**
(21) Anmeldenummer: 19173443.3
(22) Anmeldetag: 09.05.2019
(51) Int. Cl.: C23C 14/50

(54) **HALTEVORRICHTUNG ZUR AUFNAHME MEHRERER SUBSTRATE ZUR BEHANDLUNG DERSELBEN, BEHANDLUNGSANLAGE UND BEHANDLUNGSVERFAHREN**
HOLDING DEVICE FOR HOLDING A PLURALITY OF SUBSTRATES FOR THE TREATMENT OF THE SAME, TREATMENT PLANT AND METHOD OF TREATMENT
DISPOSITIF DE RETENUE PERMETTANT DE RECEVOIR UNE PLURALITÉ DE SUBSTRATS DESTINÉ AU TRAITEMENT DESDITS SUBSTRATS, INSTALLATION DE TRAITEMENT ET PROCÉDÉ DE TRAITEMENT

(30) Priorität: 09.05.2018 DE 102018111247
(43) Veröffentlichungstag der Anmeldung: 13.11.2019
(73) Patentinhaber: Solayer GmbH, 63791 Karlstein (DE)
(72) Erfinder: Liepack, Harald, 01159 Dresden (DE); Merz, Thomas, 63743 Aschaffenburg (DE); Wissel, Sebastian, 63791 Karlstein (DE); Rack, Andreas, 63538 Großkrotzenburg (DE)
(74) Vertreter: Lippert Stachow Patentanwälte Rechtsanwälte Partnerschaft mbB

(56) Entgegenhaltungen:
- US-A- 4 817 559
- US-A1- 2012 186 522
- US-A1- 2013 074 767

## Beschreibung

Die Erfindung betrifft eine Haltevorrichtung zur Aufnahme mehrerer Substrate, welche in einer dafür vorgesehenen Behandlungsanlage behandelt werden sollen. Die Erfindung betrifft ebenso eine solche Behandlungsanlage sowie ein Behandlungsverfahren, welche eine Ausführung der nachfolgend beschriebenen Haltevorrichtung verwenden.

Eine Behandlungsanlage zur Behandlung von Substraten umfasst gattungsgemäß eine Anlagenkammer oder eine Abfolge mehrerer Anlagenkammern, in welcher die Substrate, gehalten durch eine geeignete Haltevorrichtung, transportiert und der Einwirkung mindestens einer Substratbehandlungseinrichtung ausgesetzt werden. Die Substratbehandlung findet dabei unter einer speziellen Prozessatmosphäre statt, oftmals unter Vakuum bei gesteuert eingelassenen Gas oder Gasgemisch.

Als "Kammer" wird üblicherweise ein durch Kammerwände umschlossener Raum bezeichnet, der zum umgebenden Raum abgegrenzt und gegebenenfalls vakuumtechnisch abschließbar ist. Eine Behandlungsanlage kann in Abhängigkeit vom Umfang der Behandlungen und von der Substratgröße eine oder mehr Behandlungskammern aufweisen. Eine Behandlungskammer kann einen einzigen Behandlungsabschnitt umfassen oder selbst wiederum in mehrere funktionell unterscheidbare Abschnitte unterteilt werden.

Unterschiedlichste, häufig flache Substrate, beispielsweise zur Herstellung von Halbleiterbauelementen, für Architektur- oder Photovoltaikanwendungen, optische Gläser und andere, werden verschiedenen Behandlungen unterzogen. Als Behandlung sollen hier die bekannten modifizierenden, additiven und subtraktiven Behandlungen verstanden sein, d.h. Prozesse, bei denen das Substrat oder auf dem Substrat vorhandene Schichten strukturell oder energetisch verändert, Material auf dem Substrat abgeschieden oder vom Substrat entfernt wird.

Neben der Substratbeschichtung, beispielsweise mittels physikalischer Vakuumbeschichtung, mit verschiedenen Schichten und Schichtsystemen sind unter anderem Plasmabehandlungen oder Sputterätzen gängige Substratbehandlungsverfahren. Die Behandlung erfolgt regelmäßig in Verbindung mit weiteren Verfahrensschritten, wobei große Stückzahlen und eine hohe Effizienz der Behandlung für die industrielle Anwendung regelmäßig gefordert werden. Derartige Behandlungsanlagen sind als Durchlauf- oder als Clusteranlagen bekannt.

Die zu beschichtenden Substrate werden während der Behandlung durch Haltevorrichtungen gehalten, welche eines oder mehrere Substrate zur gleichzeitigen Behandlung aufnehmen können. Derartige Haltevorrichtungen sind so ausgeführt, dass die zu behandelnde Fläche nicht oder nur in geringem Maße bedeckt ist und die Substrate einfach, auch automatisiert und ohne Beschädigung der zu beschichtenden bzw. der bereits beschichteten Fläche zugeführt, behandelt und nach der Behandlung entnommen werden können. Sie dienen auch einem Transport der Substrate in der Behandlungsanlage.

Der Transport kann durch translatorische Bewegung, Rotationsbewegung oder eine Bewegung entlang einer anderen definierten Bewegungsbahn erfolgen. Je nach Art der Bewegung können unterschiedliche Kräfte auf die Substrate einwirken, welche von der Haltevorrichtung aufgenommen werden müssen, um eine präzise und reproduzierbare Positionierung der Substrate für die Behandlungen zu gewährleisten.

Die Haltevorrichtungen umfassen häufig sogenannte Carrier, welche der Haltevorrichtung entnehmbar und zuführbar sind und dabei ein Substrat oder mehrere davon aufnehmen. Die Carrier sind in ihrer Form im Wesentlichen an die Gestalt der Substrate angepasst. Darüber hinaus sind sie für das auszuführende Handling, wie beispielsweise die Überführung der Substrate zwischen Magazin und Behandlungsanlage, die Ausrichtung des Substrats und andere der von Behandlungsanlagen bekannten Maßnahmen, adaptiert.

Erfolgt in einer Behandlungsanlage ein Wechsel der Substrattypen oder Substratgrößen ist folglich ein Wechsel der Carrier und damit ein Wechsel oder eine Modifizierung der Haltevorrichtung notwendig, womit umfangreiche Umbaumaßnahmen und Stillstandszeiten der Anlage verbunden sind. In der Patentschrift US 4,817,559 und der Patentanmeldung US 20120/0186522 A1 werden beispielsweise Kreisringsegmente mit kreisrunden Öffnungen zur Aufnahme kreisrunder optischer Substrate beschrieben. Jeweils ein Substrat wird in einer der Öffnungen durch eine Klammer gehalten. Die Komponenten zur Halterung der Substrate sind an die beschriebene Art und Geometrie der Substrate anagepasst. Ist eine Haltevorrichtung für verschiedene Substrattypen und/oder Substratgrößen konzipiert, können diese Nachteile zwar reduziert sein. Jedoch verringert sich häufig die für die gleichzeitige Behandlung von Substraten nutzbare Fläche. Gleiches trifft auf die US 2013/74767 A1 zu. Auch deren Haltevorrichtung für die Substrate ist auf plattenförmige, rechteckige Substrate, die sich zudem überlappen, ausgerichtet.

Es besteht daher ein Bedürfnis nach Haltevorrichtungen, welche für verschiedene Substrattypen und Substratgrößen anpassbar ist und dabei eine verbesserte Ausnutzung der Behandlungsfläche gestattet. Gleichzeitig soll die Haltevorrichtung für das automatische Handling der Substrate in den Behandlungsanlagen nutzbar sein.

Es besteht insbesondere ein Interesse an einer rotierbaren Haltevorrichtung, bei welcher mitunter auch hohe Drehzahlen und damit hohe Kräfte und Momente auftreten.

Zur Lösung der Aufgabe wird eine Haltevorrichtung nach Anspruch 1, eine Behandlungsanlage nach Anspruch 10 sowie ein Behandlungsverfahren nach Anspruch 12, welche die Haltevorrichtung verwenden, vorgeschlagen. Die sich auf diese Ansprüche beziehenden abhängigen Ansprüche beschreiben zweckmäßige Ausgestaltungen der Haltevorrichtung, der Behandlungsvorrichtung und des Behandlungsverfahrens.

Das wesentliche Konzept der Erfindung ist dahingehend zu beschreiben, dass mit der Einführung von standardisierbaren Komponenten, welche die Carrier aufnehmen, eine standardisierbare Schnittstelle bereitgestellt wird zwischen einer primär der Aufnahme und Übertragung der Kräfte dienenden Baugruppe und einer Baugruppe, welche primär für die Anforderungen der Aufnahme von Substraten verschiedenen Designs konzipiert ist. Dadurch können die Bestandteile der Haltevorrichtung ab der standardisierbaren Schnittstelle und nicht lediglich die Carrier automatisiert gehandhabt werden.

Die Schnittstelle selbst kann so auf die optimale Halterung dieser aufzunehmenden Komponenten ausgerichtet sein sowie auf die häufige Be- und Entladung der Haltevorrichtung mit Substraten. Für die Beladung der Haltevorrichtung in einer Behandlungsanlage sind Lade- und Magazinsysteme verwendbar, welche unabhängig sind von den Carrier- und Substratformaten. Eine optimale Halterung schließt somit sowohl die für die Fixierung und Kraftübertragung erforderlichen Verbindungsflächen und Verbindungsmittel ein als auch deren automatisierbare Nutzung im Verlauf einer kompletten Losgröße.

Eine Halterung der Substrate, welche deren zu behandelnde Flächen minimal überdeckt, ist mit der erfindungsgemäßen Haltevorrichtung erst ab der Substrathalterung durch die Carrier zu berücksichtigen.

Nachfolgend werden zur Realisierung des Konzepts verwendete Merkmale beschrieben. Diese wird der Fachmann in verschiedenen Ausführungsformen verschieden miteinander kombinieren, soweit ihm das für einen Anwendungsfall sinnvoll und geeignet erscheint.

Die Haltevorrichtung umfasst einen Flansch, an welchem ein oder mehrere Segmente angeordnet sind, wobei die Segmente Carrier aufweisen. Der Flansch ist als kreisförmige Platte ausgebildet, an welche radial angeordnete Träger montiert sind. Die Anordnung der Segmente am Flansch erfolgt mittels Verbindungsflächen, die in Größe, Lage und Verteilung dem aufzunehmenden Segment und der zu erwartenden, auf die Verbindungsflächen wirkenden Kräfte angepasst sind. Eine solche Anpassung erfolgt konstruktiv mittels Tests oder rechnergestützter Simulation.

Als Flansch ist hier jener Teil der Haltevorrichtung bezeichnet, welcher von der Transportvorrichtung einer Behandlungsanlage aufnehmbar und zur Übertragung der Kräfte der Transportvorrichtung auf die Haltevorrichtung verwendbar ist. Letztendlich dient die Haltevorrichtung mittels ihrer weiteren Elemente der Übertragung der Kräfte der Transportvorrichtung auf die Substrate zu deren Bewegung und Positionierung im Verlauf der Behandlung.

Der Flansch kann in Abhängigkeit von der Art und Größe der Substrate, der Gestaltung der Behandlungsanlage und auszuführender Bewegungen verschiedene Formen aufweisen. Er kann axialsymmetrisch, rotationssymmetrisch oder andere asymmetrische Design aufweisen und kann weitere Komponenten umfassen.

Das Segment oder die Segmente können, je nach Art und Lage der Verbindungsflächen lose mit dem Flansch verbunden oder zerstörungsfrei lösbar am Flansch befestigt sein. Dementsprechend können die Verbindungsflächen verschieden ausgeführt sein. Ein loses Auflegen ist beispielsweise durch horizontale Verbindungsflächen möglich, die am Flansch ausgebildet sind oder durch geeignete Träger, wie T- oder I-Träger oder andere Trägerformen, bereitgestellt werden. Eine lösbare Befestigung ist bei solchen und anderen Verbindungsflächen mit geeigneten Befestigungsmitteln möglich.

Die Halterung und/oder Befestigung der Segmente am Flansch können durch geeignete Haltemittel realisiert sein, welche nur halten, gleichzeitig halten und befestigen oder welche voneinander separierte Mittel zum Halten und zum Befestigen aufweisen. Dementsprechend können die Haltemittel am Flansch und/oder an den Segmenten ausgebildet sein. Die Haltemittel sind derart ausgebildet, dass sie eine Entnahme und eine Befestigung der Segmente mittels eines, optional remote steuerbaren, Handlingssystems gestatten. Solche Haltemittel können unter anderem mechanische Klicksysteme, magnetische oder elektrisch bedienbare Halterungen oder auf andere Weise ausgebildet sein.

Die Segmente umfassen ein Segmenttragwerk und zumindest einer Carrier, welcher direkt oder mittels weiterer Elemente am Segmenttragwerk montiert sind. Als Segmenttragwerk sind solche Gestaltungen gemeint, die im Sinne eines Gestelles, Trägers, Rahmens oder ähnlichem geeignet sind, den oder die mit Substraten bestückten Carrier im Verlauf der Behandlung und der Bewegung der Carrier zu halten.

Die weiteren Elemente können geeignete Haltemittel, Bleche oder andere sein, welche beispielsweise die Montage der Carrier oder die minimal überdeckende Aufnahme der Substrate unterstützen.

Die lösbare Verbindung der Segmente am Flansch erfolgt mittels des Segmenttragwerks. Die Haltemittel oder Teile davon können zu diesem Zweck am Segmenttragwerk ausgebildet sein.

Am Segmenttragwerk ist ein Carrier, beispielsweise ein plattenförmiges Element, oder mehrere davon montiert. Dessen Ausführung zur Halterung der zu behandelnden Substrate ist deren Gestalt angepasst.

In Abhängigkeit verschiedener Parameter, wie Größe und Gestalt eines Segments und/oder Größe und Gestalt eines Substrats kann der Carrier auch mehrteilig ausgebildet sein.

In dieser Ausgestaltung kann eine Carrierkomponente eine Halterung, beispielsweise ein Halterahmen oder andere sein, welche vom Carrier lösbar ist und das Handling beispielsweise von kleinen oder dünnen oder hohen Stückzahlen von Substraten verbessert.

Optional kann zwischen Segmenttragwerk und Carrier oder zwischen zwei Carrierkomponenten eine Verbindungsstelle analog jener zwischen Flansch und Segmenttragwerk ausgebildet sein, so dass eine Entnahme eines ein Substrat haltenden Carriers oder einer Carrierkomponente mittels eines Handlingssystems der Behandlungsvorrichtung wie zuvor beschrieben möglich ist. Eine solche Verbindungsstelle kann als weitere standardisierte Schnittstelle eingefügt sein. In diesem Fall ist das Handling der vom Carrier oder der Carrierkomponente gehaltenen Substrate optimiert und automatisierbar. Zudem ist auch in solchen Ausgestaltungen der Vorteil der einfachen Adaption der Haltevorrichtung bei einem Wechsel des Substratdesigns mittels Austausch der Segmente wie zuvor beschrieben weiterhin nutzbar.

Der Carrier kann lose mit dem Segmenttragwerk verbunden oder mittels geeigneter weiterer, auch automatisiert bedienbarer, Haltemittel zerstörungsfrei lösbar am Segmenttragwerk befestigt sein. Die Verbindung zwischen Carrier und Segmenttragwerk hängt unter anderem von der Gestalt und Größe der Substrate, der bei der Bewegung der Substrate in der Behandlungsanlage auftretenden Kräfte sowie dem Ort des Austauschs der Carrier ab, d. h. ob der Austausch innerhalb der Behandlungsanlage während des laufenden Betriebs erfolgt oder nicht. Der Carrier ist zur Aufnahme von einem oder mehreren Substraten ausgebildet.

Die Gliederung der Haltevorrichtung in Flansch, entnehmbare Segmente und deren Ausführung aus Segmenttragwerk und lösbaren Carriern gestattet die Verwendung einer Haltevorrichtung für hinsichtlich Form, Dicke und Größe variable Substrate. In einer Haltevorrichtung können gleichzeitig unterschiedliche Substrate mit voneinander abweichender Geometrie gehalten werden.

Mittels der austauschbaren, variabel gestaltbaren und optional mehrteiligen Carrier kann die Carrierfläche optimal zur Aufnahme von Substraten ausgenutzt und die gleichzeitig behandelbare Substratfläche im Vergleich zum Stand der Technik vergrößert werden.

Das Segmenttragwerk bildet in Verbindung mit den besagten Haltemitteln die Schnittstelle zwischen Flansch und Carrier. Diese ist standardisierbar, wenn Segmente zwar unterschiedliche Carrier, jedoch einheitliche Segmenttragwerke und einheitliche Haltemittel aufweisen. Infolge der Entnehmbarkeit der Segmente können bei Substratwechsel andere, mit geeigneten Carriern ausgerüstete Segmente verwendet werden, ohne dass ein zeitaufwendiger Umbau der Haltevorrichtung notwendig wird. Für die modifizierten Segmente sind weiterhin die Handlings- und Magazinsysteme der Behandlungsanlage verwendbar. Auch das Ein- und Ausschleusen der Segmente aus einer Vakuumanlage ist auf diese Weise möglich.

Gleiches kann auch auf den Carrier oder die Carrierkomponente in Verbindung mit deren Haltemitteln zur lösbaren Montage der Carrier oder Carrierkomponente zutreffen, wenn deren Verbindungstelle zum Segmenttragwerk bzw. zur benachbarten Carrierkomponente analog ausgebildet ist.

Die Entnehmbarkeit der Segmente und gegebenenfalls Carrier oder Carrierkomponenten gestattet es zudem, jene Teile der Haltevorrichtung regelmäßig zu entnehmen und auszutauschen, welche infolge der Behandlung, insbesondere der Beschichtung, einen erhöhten Wartungsaufwand haben. zudem sind ein Carrier oder das Segmenttragwerk zumindest eines Segments oder beide Komponenten derart ausgebildet, dass sie im Zustand der Halterung des Carriers durch die Haltevorrichtung die Verbindungsflächen am Flansch zumindest teilweise zu überdecken. Dies wird durch eine Gestaltung der Segmenttragwerke und/oder Carrier unterstützt, welche Blendenabschnitte aufweisen. Diese können geeignete Vor- und Rücksprünge im Randbereich des Segments sein, welche so angeordnet sind, dass sie insbesondere von der Behandlung der Substrate betroffene Bauteile der Haltevorrichtung bedecken, d. h. als Blende wirken. Beispielsweise kann der Carrier die Halte- und Befestigungsmittel und Teile des Flansches bedecken. Auch eine Mehrfachbedeckung zur Ausbildung eines einem Labyrinth ähnlichen Systems von Blenden ist möglich, womit beispielsweise Streudampf abschirmbar ist.

Eine Behandlungsanlage zur Behandlung von Substraten, welche eine Haltevorrichtung gemäß voranstehender Beschreibung umfasst, weist regelmäßig eine Behandlungskammer mit zumindest einem Behandlungsabschnitt, beispielsweise einem Beschichtungsabschnitt, oder mehrere solcher Behandlungskammern auf. Weitere Kammern und Abschnitte die der Vor- und/oder Nachbehandlung der Substrate sowie der Herstellung der für die Behandlung benötigten Prozessbedingungen sind meist ebenfalls erforderlich und hängen von der Art der Behandlung ab.

Um die Substrate den einen oder mehrere Abschnitte passieren zu lassen, weist die Behandlungsanlage zudem eine Substrattransportvorrichtung auf, wie eingangs zum Stand der Technik beschrieben. Diese bewegt die zuvor beschriebene Haltevorrichtung mit den darauf angeordneten Substraten in der für die Behandlung erforderlichen Art und Weise. Zu den in Frage kommenden Bewegungsarten wird auf die Darlegungen zum Stand der Technik verwiesen.

Ein Verfahren zur Behandlung von Substraten, welches die zuvor beschriebene Behandlungsanlage verwendet, weist neben den gattungsgemäßen Verfahrensschritten, wie beispielsweise Herstellung und Aufrechterhaltung der Prozessatmosphäre, Vorbereitung und/oder Vorbehandlung der Substrate und anderen folgende Verfahrensschritte auf:
- Zunächst werden die zu behandelnden Substrate bereitgestellt. Diese bestimmen, wie zuvor zur Haltevorrichtung beschrieben, das Design der Carrier, und gegebenenfalls auch deren Befestigung am Segmenttragwerk sowie die Halterung des Segments am Flansch.
- Dementsprechend werden Segmente der zuvor beschriebenen Haltevorrichtung bereitgestellt, welche Carrier aufnehmen, die geeignet sind, die Substrate während eines Substrattransports und einer Behandlung zu halten.
- Die Substrate werden mittels eines geeigneten Handlingssystems, optional auch manuell, auf den Carriern angeordnet.
- Die mit den Substraten bestückten Carrier werden am Segmenttragwerk montiert. Letzteres schließt nicht zwingend spezielle Befestigungsmittel ein. Die Montage erfordert lediglich, dass die Lage der Carrier während der Behandlung definiert ist und bleibt. Das kann beispielsweise mit Führungsschienen, Lagepins oder ähnlichen einfachen mechanischen Hilfsmitteln oder mittels anderer ergänzender Komponenten der Segmente erfolgen.
- Die Segmenttragwerke und die mit Substraten bestückten Carrier werden in die Behandlungsanlage eingeführt und auf der Haltevorrichtung der Behandlungsanlage wie zuvor beschrieben montiert.
- In der Behandlungsanlage erfolgt die Behandlung der von den Segmenten gehaltenen Substrate. Sofern erforderlich werden diese mittels der Haltevorrichtung und einer geeigneten Transportvorrichtung der Behandlungsanlage in der Anlage, optional durch die Anlage bewegt und nacheinander verschiedenen Verfahrensschritten unterworfen.
- Nach Beendigung der Behandlung werden die Segmente, optional nur die Carrier, mit den behandelten Substraten aus der Behandlungsanlage ausgeführt.

Die Reihenfolge der zuvor beschriebenen Verfahrensschritte kann entsprechend der Ausgestaltung der Verbindungsstellen zwischen Segment und Flansch, zwischen Carrier und Segmenttragwerk oder zwischen den Carrierkomponenten voneinander abweichen.

In einer Ausführung kann die Einfuhr der Substrate in die Behandlungsanlage erfolgen, wenn sie mit den Carriern bereits am Segmenttragwerk angeordnet sind, so dass ein vollständig bestücktes Segment in die Behandlungsanlage eingeführt wird.

In einer alternativen Ausführung kann die Einfuhr der Substrate in die Behandlungsanlage erfolgen, wenn sie von den Carriern gehalten sind und sich die Segmenttragwerke bereits in der Anlage befinden. In diesem Fall können für eine einfache Adaption der Haltevorrichtung an neue Substratgeometrien die Segmenttragwerke (automatisiert) ausgetauscht werden und/oder ein Wechsel zwischen den beiden Varianten zur Substrateinfuhr erfolgen.

Das Konzept des Segmenttragwerks als standardisierbare Schnittstelle unterstützt beide Varianten, wobei eine standardisierte, optional automatisiert bedienbare Schnittstelle auch zwischen Carrier und Segmenttragwerk ausgebildet sein kann.

In den genannten Verfahrensausgestaltungen können für die Substrate und/oder für die Carrier und/oder für die bestückten Segmente Magazine verwendet werden, welche eine Vielzahl der jeweiligen Objekte aufnehmen und automatisiert be- und entladen werden.

Zum besseren Verständnis soll die Erfindung nachfolgend anhand der Ausführung der Haltevorrichtung beschrieben werden, welche rotationssymmetrisch als Drehteller ausgebildet ist. Zur Behandlung der vom Drehteller gehaltenen Substrate, beispielsweise zu deren Beschichtung, werden derartige Drehteller für eine homogene Beschichtung mit hoher Geschwindigkeit fortlaufend gedreht. Der Flansch ist als kreisförmige Platte ausgebildet, an welche radial angeordnete Träger, beispielsweise T-Träger, montiert sind. Diese können über den Rand der Platte hinausragen und Segmente in Form von Kreisringsegmenten aufnehmen. Die Segmente können beispielsweise auf den horizontal liegenden Profilteilen der T-Träger aufliegen und zur Fixierung lösbar befestigt werden.

Die zuvor in den verschiedenen Ausgestaltungen der Erfindung und der nachfolgend beschriebenen Ausführungsform realisierten Merkmale würde der Fachmann in anderen Anwendungen und weiteren Ausführungsformen modifizieren oder kombinieren soweit es ihm zweckdienlich und sinnvoll erscheint.

Die zugehörigen Zeichnungen zeigen in
Fig. 1 die erfindungsgemäße Haltevorrichtung,
Fig. 2 den Flansch der Haltevorrichtung aus Fig. 1,
Fig. 3 eine Ausführungsform eines Segments, welches in einer Haltevorrichtung nach Fig. 1 verwendbar ist,
Fig. 4 die Ausführung der Randbereiche von zwei benachbarten Segmenten als Blenden,
Fig. 5A bis Fig. 5C ein Segment in verschiedenen Ausbaustufen und
Fig. 6 eine Ausführung einer Behandlungsanlage, welche eine Haltevorrichtung nach Fig. 1 umfasst.

Die nachfolgend beschriebenen Figuren dienen lediglich der Erläuterung von Merkmalen der Erfindung. Sie erheben keinen Anspruch auf Vollständigkeit oder Maßstäblichkeit.

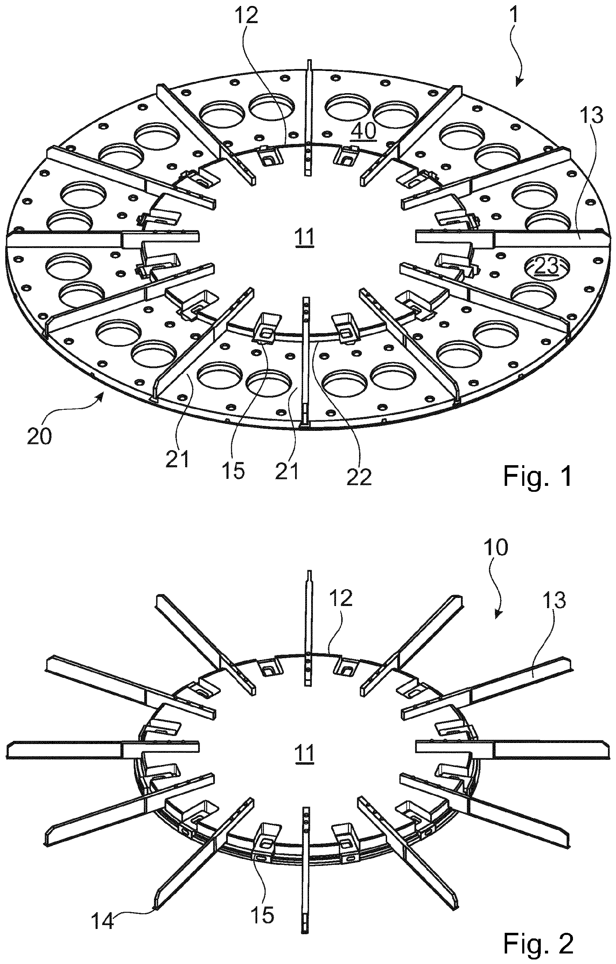

Die als Drehteller 1 ausgebildete Haltevorrichtung in Fig. 1 umfasst einen Flansch 10, mit einer Trägerplatte 11, welche im Ausführungsbeispiel als kreisförmige Mittelplatte ausgebildet ist. An der Trägerplatte 11 sind zwölf strahlförmig nach außen verlaufende und über den Rand 12 der Trägerplatte 11 hinausragende Träger 13 befestigten. Die Träger 13 sind beispielsweise als T-Profilträger ausgebildet, deren Querbalken 14 den unteren Abschluss bilden.

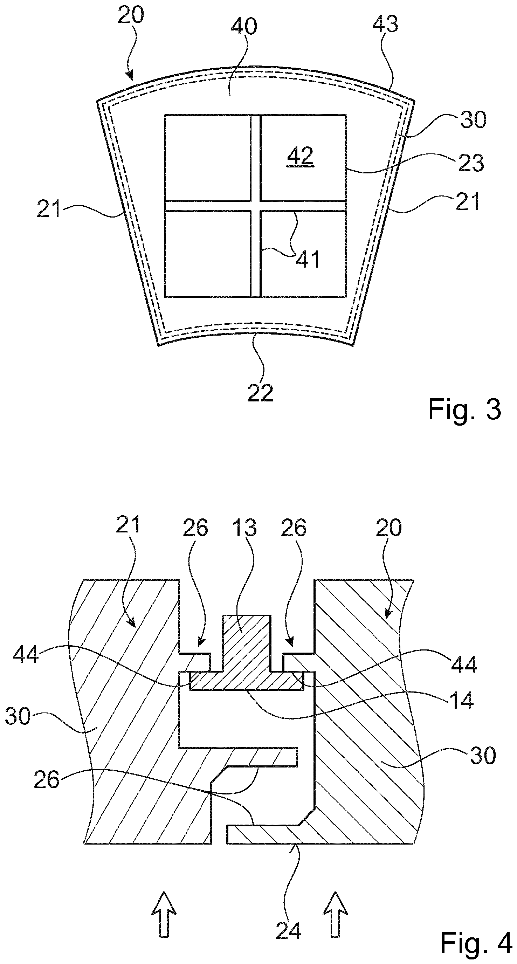

Zwischen den Trägern 13 und direkt an den Rand 12 der Trägerplatte 11 anschließend sind zwölf kreisringsegmentförmige, gleichartige Segmente 20 angeordnet. Jedes Segment 20 weist in seinem Carrier 40 zwei kreisförmige Öffnungen 23 auf, welche auf geeignete Weise zur Aufnahme von kreisförmigen Substraten (nicht dargestellt) ausgebildet sind. Die Segmente 20 liegen in ihren beiden seitlichen Randbereichen 21 auf dem Querbalken 14 jeweils eines Trägers 13 auf. Die Träger 13 ragen beispielhaft mit einer solchen Länge über den Rand 12 der Trägerplatte 11 hinaus, dass sie bündig mit den Segmenten 20 abschließen. Die Komponenten der Segmente 20 sowie Auflagen im seitlichen Randbereich 21 sind in Fig. 4 im Detail dargestellt und dort beschrieben.

Fig. 2 zeigt die Trägerplatte 11 mit den Trägern 13 und den Haltemitteln 15 ohne Segmente 20. Den Fig. 1 und Fig. 2 ist zu entnehmen, dass die Trägerplatte 11 benachbart zum inneren Randbereich 22 eines jeden Segments 20 ein geeignetes Haltemittel 15 aufweist, welches im "geschlossenen" Zustand das Segment 20 in der dargestellten radialen Position hält und ferngesteuert zumindest zu öffnen, optional auch ferngesteuert zu schließen ist.

Fig. 3 zeigt eine alternative Ausführung eines Segments 20, welches die gleichen Abmessungen, die gleiche äußere Form und die gleichen Auflagen im seitlichen Randbereich 21 wie jenes aus Fig. 1 hat und folglich alternativ zu letzterem in der Haltevorrichtung der Fig. 1 verwendbar ist. Das Segment 20 umfasst ein Segmenttragwerk 30, welches im Ausführungsbeispiel in Form eines Segmentrahmens ausgebildet ist und welches an welchem ein plattenförmiges Element 43 montiert ist, so dass es das Segmenttragwerk 30 zumindest einseitig überdeckt. Das plattenförmige Element 43 bildet den Carrier 40.

Der Carrier 40 weist mittig eine rechteckige Öffnung 23 auf, welche durch Stege 41 in vier Carrieröffnungen 42 unterteilt ist. Jede Carrieröffnung 42 ist zur Aufnahme eines rechteckigen Substrats (nicht dargestellt) ausgebildet. Das Segment 20 aus Fig. 3 unterscheidet sich von jenen aus Fig. 1 lediglich durch die Form der Öffnung 23, so dass im Weiteren auf die dortigen Darlegungen verwiesen wird. Anstelle der in den Figuren gezeigten viereckigen oder runden Substratformen können auch beliebige andere Geometrien mit den Segmenten (20) in der Haltevorrichtung angeordnet werden.

In Fig. 4 sind die beiden seitlichen Randbereiche 21 von zwei benachbarten Segmenten 20 im Schnitt dargestellt. Jedes Segment 20 umfasst ein Segmenttragwerk 30. Die seitlichen Randbereiche 21 beider Segmente 20 zeigen die Segmenttragwerke 30, welche Vor- und Rücksprünge derart aufweisen, dass Auflagekanten 44 zur Auflage des Segments 20 auf dem Querbalken 14 des Trägers 13 gebildet sind. Die Vor- und Rücksprünge sind derart ausgeführt, dass der Zwischenraum zwischen beiden Segmenten 20 mäanderförmig oder labyrinthartig gestaltet ist und der Träger 13 von der Unterseite 24 der Segmente 20 gesehen, welche im Ausführungsbeispiel die Beschichtungsseite (dargestellt durch Pfeile) ist, nicht sichtbar und damit vor ungewollter Beschichtung geschützt ist. Die Auflagekanten 44 bilden jeweils in Verbindung mit dem Querbalken 14 des zugehörigen Trägers die Haltemittel 15 für die Segmente 20.

Die Verblendung des Trägers 13 gegenüber einer Beschichtung können auch auf andere Weise und unter Nutzung anderer oder ergänzender Bauteile der Segmente realisiert werden, beispielsweise durch überlappende Vorsprünge 26 zumindest eines unteren plattenförmigen Elements 43 und/oder zumindest eines Segmenttragwerks 30.

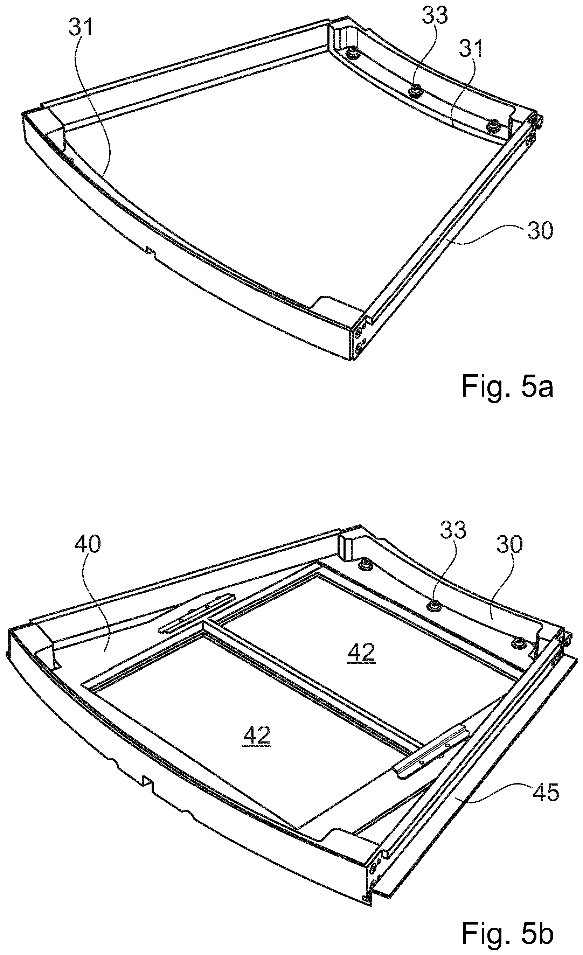

Fig. 5A zeigt ein Segmenttragwerk 30, wie es in Fig. 3 verwendet werden kann. Am unteren und oberen Randabschnitt, welche durch jeweils einen Kreisbogen gebildet sind, weist das Segmenttragwerk 30 weitere Haltemittel auf, die der Halterung des Carriers 40 am Segmenttragwerk 30 dienen und als Carrierhaltemittel 31 bezeichnet sein sollen. Die Carrierhaltemittel 31 sind als horizontale Flächen mit Schraubverbindern 33 ausgebildet. Andere Carrierhaltemittel sind alternativ möglich.

Fig. 5B zeigt das Segmenttragwerk 30 der Fig. 5A, ergänzt durch einen Carrier 40, welcher an den Schraubverbindern 33 montiert ist und das Segmenttragwerk 30 unterseitig bedeckt. Der Carrier 40 weist eine schmale Abkantung 45 in Höhe des halben Segmenttragwerks 30 auf. Die Abkantung 45 hat den gleichen abschirmenden Effekt, wie der Vorsprung 26 in Fig. 4.

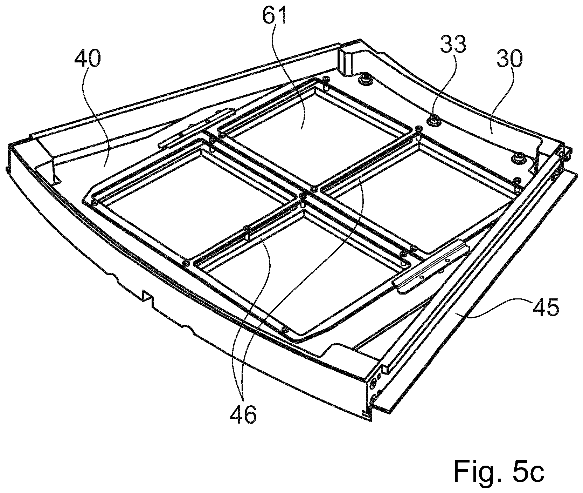

Der Carrier 40 weist zentral zwei rechteckige Carrieröffnungen 46 auf, in welchen mittels Halterahmen 46 jeweils ein Paar Substrate 61 angeordnet sind (Fig. 5C). Die derart bestückten Segmente 20 können in eine Behandlungsanlage eingeführt werden, um dort von unten behandelt, beispielsweise beschichtet, zu werden.

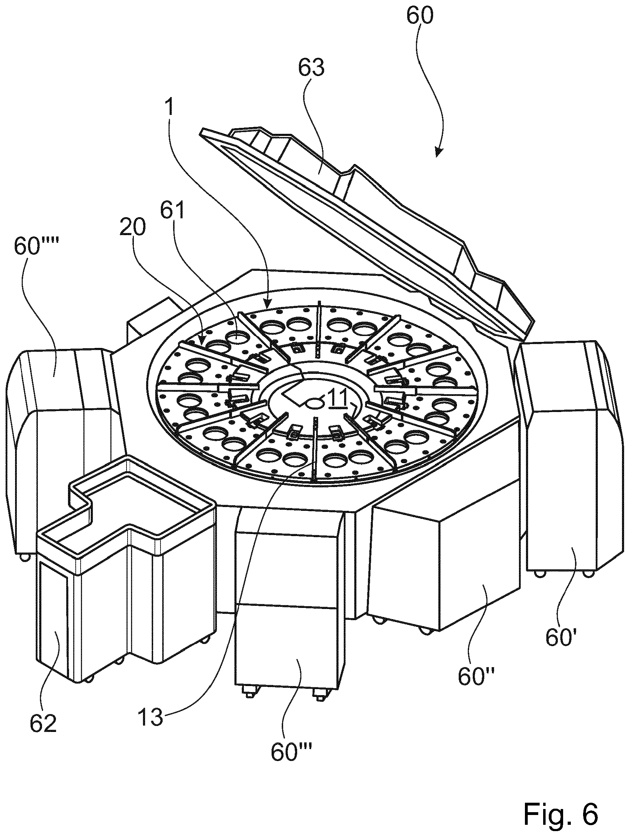

Fig. 6 zeigt eine geöffnete Behandlungsanlage 60, welche eine Haltevorrichtung 1 gemäß Fig. 1 verwendet. Zu den Details der Haltevorrichtung wird auf die Darlegungen zu Fig. 1 bis Fig. 5C verwiesen. Die Behandlungsanlage 60 hat einen kreisrunden Aufbau und weist auf ihrem Umfang verteilt mehrere Stationen 60' ... 60‴′ auf, die direkt oder indirekt der Behandlung von Substraten 61 dienen.

Die Substrate 61 sind in den Segmenten 20 angeordnet und werden an zumindest einer der Stationen 60' ... 60‴′ behandelt. Es ist augenscheinlich, dass die Behandlungsstation 60 während der Behandlung mittels ihres Deckels 63 geschlossen ist.

Die Haltevorrichtung 1 ist mit den Segmenten 20 ausgerüstet. In einer Ladestation 62 sind Magazine (nicht dargestellt) angeordnet, in welchen Segmente 20 mit Substraten 61 vorgehalten werden. Durch eine schrittweise Rotation der Haltevorrichtung 1 mittels einer geeigneten Substrattransportvorrichtung, welche die Rotation ausführt, durchlaufen die Substrate 61 nach und nach die einzelnen Stationen 60' ... 60‴′ einschließlich der Behandlungsstation(en), so dass an der Ladestation 62 die Segmente 20 mit bereits behandelten Substraten 61 entnommen und Segmente 20 mit unbehandelten Substraten 61 in der Haltevorrichtung 1 montiert werden können.

### Bezugszeichenliste

- 1: Haltevorrichtung, Drehteller
- 10: Flansch
- 11: Trägerplatte
- 12: Rand
- 13: Träger
- 14: Querbalken
- 15: Haltemittel
- 20: Segment
- 21: seitlicher Randbereich
- 22: innerer Randbereich
- 23: Öffnung
- 24: Unterseite
- 26: Vorsprung
- 30: Segmenttragwerk
- 31: Carrierhaltemittel
- 33: Schraubverbinder
- 40: Carrier
- 41: Steg
- 42: Carrieröffnung
- 43: plattenförmiges Element
- 44: Auflagekante
- 45: Abkantung
- 46: Halterahmen
- 60: Behandlungsanlage
- 60' - 60‴′: Stationen
- 61: Substrat
- 62: Ladestation
- 63: Deckel

## Patentansprüche

1. Haltevorrichtung verwendbar für die Aufnahme mehrerer Substrate in einer Substratbehandlungsanlage, folgende Komponenten umfassend:
- einen Flansch (10), welche als kreisförmige Platte mit radial an der Platte montierten Trägern (13) ausgebildet ist,
- zumindest ein Segment (20), welches am Flansch (10) lösbar und der Haltevorrichtung entnehmbar angeordnet ist;
- wobei zumindest die Träger (13) des Flansches (10) Verbindungsflächen zur Anordnung des zumindest einen Segments (20) am Flansch (10) aufweisen;
- wobei das zumindest eine Segment (20) ein Segmenttragwerk (30) aufweist,
- wobei die lösbare Verbindung des zumindest einen Segments am Flansch mittels des Segmenttragwerks erfolgt;
- zumindest einen Carrier (40) für die Aufnahme eines oder mehrerer Substrate (61), welcher am Segmenttragwerk (30) montiert ist,
- wobei ein Carrier (40) oder das Segmenttragwerk (30) des zumindest einen Segments (20) oder beide Komponenten ausgebildet sind im Zustand der Halterung des Carriers (40) durch die Haltevorrichtung (1) die Verbindungsflächen am Flansch (10) zumindest teilweise zu überdecken.

2. Haltevorrichtung nach Anspruch 1, wobei das Segment (20) lose mit dem Flansch (10) verbunden oder zerstörungsfrei lösbar am Flansch (10) befestigt ist.

3. Haltevorrichtung nach einem der vorstehenden Ansprüche, wobei der Flansch (10) oder das zumindest ein Segment (20) oder beide Komponenten Haltemittel (15) zur Halterung oder zur Befestigung oder Halterung und Befestigung des Segments (20) am Flansch (10) aufweist bzw. aufweisen.

4. Haltevorrichtung nach Anspruch 3, wobei ein Carrier (40) oder das Segmenttragwerk (30) des zumindest einen Segments (20) oder beide Komponenten ausgebildet sind im Zustand der Halterung des Carriers (40) durch die Haltevorrichtung (1) die Haltemittel (15) zumindest teilweise zu überdecken.

5. Haltevorrichtung nach Anspruch 3 oder 4, wobei Haltemittel (15) des Segments (20) oder Teile davon am Segmenttragwerk (30) angeordnet sind.

6. Haltevorrichtung nach einem der vorstehenden Ansprüche, wobei der zumindest eine Carrier (40) derart lose mit dem Segmenttragwerk (30) verbunden oder zerstörungsfrei lösbar am Segmenttragwerk (30) befestigt ist, dass er mit dem Substrat gemeinsam vom Flansch entnommen werden kann.

7. Haltevorrichtung nach einem der vorstehenden Ansprüche, wobei ein Carrier (40) oder das Segmenttragwerk (30) des zumindest einen Segments (20) oder beide Komponenten Blendenabschnitte aufweisen, welche durch Vor- und Rücksprünge im Randbereich des Segments ausgebildet und so angeordnet sind, dass sie im Zustand der Halterung des Carriers (40) durch die Haltevorrichtung (1) die Verbindungsflächen am Flansch (10) oder die Haltemittel (15) oder beides zumindest teilweise überdecken.

8. Haltevorrichtung nach einem der vorstehenden Ansprüche, wobei der Carrier (40) plattenförmig oder mehrteilig ausgebildet ist.

9. Haltevorrichtung nach Anspruch 8, wobei die Segmente (20) als Kreisringsegmente ausgebildet sind.

10. Behandlungsanlage zur Behandlung von Substraten (61), folgende Bestandteile umfassend:
- zumindest eine Behandlungskammer mit zumindest einem Behandlungsabschnitt;
- eine Substrattransportvorrichtung ausgebildet zur Bewegung von Substraten (61) in der Behandlungsanlage;
- wobei die Substrattransportvorrichtung eine Haltevorrichtung (1) zur Aufnahme mehrerer Substrate (61) nach einem der vorstehenden Ansprüche aufweist.

11. Behandlungsanlage nach Anspruch 10, wobei der Behandlungsabschnitt ein Beschichtungsabschnitt zur Abscheidung einer Oberflächenschicht auf den Substraten (61) ist.

12. Verfahren zur Behandlung von Substraten (61) in einer Behandlungsanlage (60) nach Anspruch 10 oder 11, folgende Verfahrensschritte umfassend:
- Bereitstellung von zu behandelnden Substraten (61);
- Bereitstellen von Segmenten (20) einer Haltevorrichtung (1) nach einem der Ansprüche 1 bis 9, welche ausgebildet sind zur Aufnahme von Carriern (40), die geeignet sind, die Substrate (61) während eines Substrattransports und einer Behandlung zu halten;
- Anordnung der Substrate (61) auf den Carriern (40);
- Montage der mit Substraten (61) bestückten Carriern (40) an den Segmenttragwerken (30);
- Einfuhr der Segmenttragwerke (30) und der mit Substraten (61) bestückten Carrier (40) in die Behandlungsanlage (60);
- lösbare Montage der Segmente (20) am Flansch (10) mittels Montage der Segmenttragwerke (30) an den Verbindungsflächen der Träger (13) des Flansches (10) der Haltevorrichtung (1) der Behandlungsanlage (60);
- wobei die Einfuhr der Substrate wahlweise gemeinsam mit den bereits am Segmenttragwerk angeordneten Carriern (40) erfolgt oder mit den Carriern (40), nachdem sich die Segmenttragwerke bereits in der Behandlungsanlage befinden;
- Behandlung der Substrate (61); und
- nach Beendigung der Behandlung Ausfuhr der Segmente (20), optional nur der Carrier (40), mit den behandelten Substraten (61) aus der Behandlungsanlage (60) .

13. Verfahren nach Anspruch 12, wobei zumindest die Montage der Segmente (20) auf der Haltevorrichtung (1) automatisiert erfolgt.

14. Verfahren nach einem der Ansprüche 12 und 13, wobei die mit Substraten (61) bestückten Segmente (20) und/oder die mit Substraten (61) bestückten Carrier (40) in einem Magazin für die Einfuhr in die Behandlungsanlage (60) bereitgestellt werden.

## Claims

1. Holding device usable for holding a plurality of substrates in a substrate treatment plant, comprising the following components:
- a flange (10), which is designed as a circular plate with supports (13) mounted radially on the plate,
- at least one segment (20) which is detachably arranged on the flange (10) and removably arranged on the holding device;
- wherein at least the supports (13) of the flange (10) have connecting surfaces for arranging the at least one segment (20) on the flange (10);
- wherein the at least one segment (20) has a segment support structure (30),
- whereby the detachable connection of the at least one segment to the flange is made by means of the segment support structure;
- at least one carrier (40) for receiving one or more substrates (61), which is mounted on the segment support structure (30),
- wherein a carrier (40) or the segment support structure (30) of the at least one segment (20) or both components are designed to at least partially cover the connecting surfaces on the flange (10) when the carrier (40) is held by the holding device (1).

2. Holding device according to claim 1, wherein the segment (20) is loosely connected to the flange (10) or is attached to the flange (10) in a non-destructively detachable manner.

3. Holding device according to one of the preceding claims, wherein the flange (10) or the at least one segment (20) or both components comprises holding means (15) for holding or for fastening or holding and fastening the segment (20) to the flange (10).

4. Holding device according to claim 3, wherein a carrier (40) or the segment support structure (30) of the at least one segment (20) or both components are designed to at least partially cover the holding means (15) when the carrier (40) is held by the holding device (1).

5. Holding device according to claim 3 or 4, wherein holding means (15) of the segment (20) or parts thereof are arranged on the segment support structure (30).

6. Holding device according to one of the preceding claims, wherein the at least one carrier (40) is loosely connected to the segment support structure (30) or is detachably attached to the segment support structure (30) in a non-destructive manner in such a way that it can be removed from the flange together with the substrate.

7. Holding device according to one of the preceding claims, wherein a carrier (40) or the segment support structure (30) of the at least one segment (20) or both components have aperture sections which are formed by projections and recesses in the edge region of the segment and are arranged in such a way that, when the carrier (40) is held by the holding device (1), they at least partially cover the connecting surfaces on the flange (10) or the holding means (15) or both.

8. Holding device according to one of the preceding claims, wherein the carrier (40) is of plate-shaped or multi-part design.

9. Holding device according to claim 8, wherein the segments (20) are designed as circular ring segments.

10. Treatment plant for the treatment of substrates (61), comprising the following components:
- at least one treatment chamber with at least one treatment section;
- a substrate transport device designed for moving substrates (61) in the treatment plant;
- wherein the substrate transport device comprises a holding device (1) for holding a plurality of substrates (61) according to one of the preceding claims.

11. Treatment plant according to claim 10, wherein the treatment section is a coating section for depositing a surface layer on the substrates (61).

12. Method for treating substrates (61) in a treatment plant (60) according to claim 10 or 11, comprising the following method steps:
- provision of substrates to be treated (61);
- providing segments (20) of a holding device (1) according to any one of claims 1 to 9, which are designed to receive carriers (40) suitable for holding the substrates (61) during a substrate transport and treatment;
- arrangement of the substrates (61) on the carriers (40) ;
- assembly of the carriers (40) fitted with substrates (61) on the segment support structures (30);
- introduction of the segment support structures (30) and the carriers (40) loaded with substrates (61) into the treatment plant (60);
- detachable assembly of the segments (20) on the flange (10) by assembly of the segment support structures (30) on the connecting surfaces of the beams (13) of the flange (10) of the holding device (1) of the treatment system (60);
- wherein the substrates are optionally introduced together with the carriers (40) already arranged on the segment support structure or with the carriers (40) after the segment support structures are already in the treatment plant;
- treatment of the substrates (61); and
- after completion of the treatment, removal of the segments (20), optionally only the carriers (40), with the treated substrates (61) from the treatment plant (60) .

13. Method according to claim 12, wherein at least the assembly of the segments (20) on the holding device (1) is carried out automatically.

14. Method according to any one of claims 12 and 13, wherein the segments (20) loaded with substrates (61) and/or the carriers (40) loaded with substrates (61) are provided in a magazine for introduction into the treatment plant (60) .

## Revendications

1. Dispositif de retenue permettant de recevoir une pluralité de substrats dans une installation de traitement de substrats, comprenant les composants suivants:
- une bride (10) qui est conçue comme une plaque circulaire avec des supports (13) montés radialement sur la plaque,
- au moins un segment (20), qui est disposé de manière détachable sur la bride (10) et de manière amovible du dispositif de retenue;
- dans lequel au moins les supports (13) de la bride (10) présentent des surfaces de liaison pour l'agencement du l'au moins un segment (20) sur la bride (10);
- dans lequel l'au moins un segment (20) comprend une structure porteuse de segment (30),
- dans lequel la liaison détachable de l'au moins un segment à la bride étant réalisée au moyen de la structure porteuse de segment;
- au moins un support (40) destiné à recevoir un ou plusieurs substrats (61), qui est monté sur la structure porteuse de segment (30),
- dans lequel un support (40) ou la structure porteuse de segment (30) du l'au moins un segment (20) ou les deux composants sont conçus pour recouvrir au moins partiellement les surfaces de liaison sur la bride (10) dans l'état de retenue du support (40) par le dispositif de retenue (1).

2. Dispositif de retenue selon la revendication 1, dans lequel le segment (20) est relié de manière lâche à la bride (10) ou est fixé de manière amovible et non destructive à la bride (10).

3. Dispositif de retenue selon l'une des revendications précédentes, dans lequel la bride (10) ou l'au moins un segment (20) ou les deux composants comporte(nt) des moyens de retenue (15) pour la retenue ou pour la fixation ou la retenue et la fixation du segment (20) sur la bride (10).

4. Dispositif de retenue selon la revendication 3, dans lequel un support (40) ou la structure porteuse de segment (30) du l'au moins un segment (20) ou les deux composants sont conçus pour recouvrir au moins partiellement les moyens de retenue (15) dans l'état de retenue du support (40) par le dispositif de retenue (1).

5. Dispositif de retenue selon la revendication 3 ou 4, dans lequel des moyens de retenue (15) du segment (20) ou des parties de ceux-ci sont disposés sur la structure porteuse du segment (30).

6. Dispositif de retenue selon l'une des revendications précédentes, dans lequel l'au moins un support (40) est relié de manière lâche à la structure porteuse de segment (30) ou est fixé de manière détachable et non destructive à la structure porteuse de segment (30) de telle sorte qu'il peut être retiré de la bride conjointement avec le substrat.

7. Dispositif de retenue selon l'une des revendications précédentes, dans lequel un support (40) ou la structure porteuse de segment (30) de l'au moins un segment (20) ou les deux composants présentent des sections de diaphragme qui sont formées par des saillies et des retraits dans la zone de bordure du segment et sont disposées de telle sorte qu'elles recouvrent au moins partiellement les surfaces de liaison sur la bride (10) ou les moyens de retenue (15) ou les deux dans l'état de retenue du support (40) par le dispositif de retenue (1).

8. Dispositif de retenue selon l'une des revendications précédentes, dans lequel le support (40) est en forme de plaque ou en plusieurs parties.

9. Dispositif de retenue selon la revendication 8, dans lequel les segments (20) sont conçus comme des segments d'anneau circulaire.

10. Installation de traitement pour le traitement de substrats (61), comprenant les composants suivants:
- au moins une chambre de traitement comprenant au moins une section de traitement;
- un dispositif de transport de substrats conçu pour déplacer des substrats (61) dans l'installation de traitement;
- dans lequel le dispositif de transport de substrats présente un dispositif de retenue (1) destiné à recevoir plusieurs substrats (61) selon l'une des revendications précédentes.

11. Installation de traitement selon la revendication 10, dans laquelle la section de traitement est une section de revêtement pour déposer une couche de surface sur les substrats (61).

12. Procédé de traitement de substrats (61) dans une installation de traitement (60) selon la revendication 10 ou 11, comprenant les étapes de procédé suivantes:
- mise à disposition de substrats à traiter (61);
- fournir des segments (20) d'un dispositif de retenue (1) selon l'une des revendications 1 à 9, qui sont configurés pour recevoir des supports (40) aptes à maintenir les substrats (61) pendant un transport de substrat et un traitement;
- disposition des substrats (61) sur les carriers (40);
- montage des carriers (40) équipés de substrats (61) sur les structures porteuses de segments (30);
- importation des structures porteuses de segments (30) et des supports (40) chargés de substrats (61) dans l'installation de traitement (60);
- montage amovible des segments (20) sur la bride (10) au moyen du montage des structures porteuses de segments (30) sur les surfaces de liaison des supports (13) de la bride (10) du dispositif de retenue (1) de l'installation de traitement (60);
- l'introduction des substrats s'effectuant au choix conjointement avec les carriers (40) déjà disposés sur la structure porteuse de segments ou avec les carriers (40) après que les structures porteuses de segments se trouvent déjà dans l'installation de traitement ;
- traitement des substrats (61); et
- à la fin du traitement, exportation des segments (20), éventuellement uniquement des supports (40), avec les substrats traités (61) hors de l'installation de traitement (60).

13. Procédé selon la revendication 12, dans lequel au moins le montage des segments (20) sur le dispositif de retenue (1) est automatisé.

14. Procédé selon l'une des revendications 12 et 13, dans lequel les segments (20) garnis de substrats (61) et/ou les supports (40) garnis de substrats (61) sont préparés dans un magasin en vue de leur introduction dans l'installation de traitement (60).
